# EUROPEAN PATENT APPLICATION

(11) **EP 4 557 269 A1**
(43) Date of publication of application: **21.05.2025**
(21) Application number: 24212035.0
(22) Date of filing: 11.11.2024
(51) Int. Cl.: G09G 3/3233, H10K 59/131, H10K 59/35

(54) **DISPLAY DEVICE**

(30) Priority: 14.11.2023 KR 20230157155
(71) Applicant: Samsung Display Co., Ltd., Yongin-si, Gyeonggi-do 17113 (KR)
(72) Inventor: LIM, Dan Won, 17113 Yongin-si (KR); KIM, Hyun Joon, 17113 Yongin-si (KR); JANG, Jae Yong, 17113 Yongin-si (KR); KOO, Bon Yong, 17113 Yongin-si (KR)
(74) Representative: Walaski, Jan Filip

(57) **Abstract**

A display device includes a substrate; a circuit layer; and an element layer. The substrate includes a display area, and a non-display area disposed around the display area. The circuit layer includes a first power supply line and a second power supply line disposed in the non-display area; light emitting pixel drivers arranged to be parallel to each other in a first direction and a second direction; first power lines extending in the first direction and electrically connected between the first power supply line and the light emitting pixel drivers; second power lines extending in the first direction and transmitting a third power; and mesh auxiliary lines extending in the second direction. The mesh auxiliary lines include a first mesh auxiliary line electrically connected to the first power lines; and a second mesh auxiliary line electrically connected to the second power lines.

## Description

### CROSS-REFERENCE TO RELATED APPLICATION(S)

This application claims priority to Korean Patent Application No. 10-2023-0157155 filed on 14 November 2023, in the Korean Intellectual Property Office.

### BACKGROUND

### 1. Technical Field

The disclosure relates to a display device.

### 2. Description of the Related Art

As the information society develops, the demand for a display device for displaying an image is increasing in various forms. For example, display devices have been applied to various electronic devices such as smartphones, digital cameras, laptop computers, navigation devices, and smart televisions.

The display device may be a flat panel display device such as a liquid crystal display device, a field emission display device, or a light emitting display device. The light emitting display device may include an organic light emitting display device including an organic light emitting element, an inorganic light emitting display device including an inorganic light emitting element such as an inorganic semiconductor, and a micro light emitting display device including a micro light emitting element or a nano light emitting display device including a nano light emitting element.

The organic light emitting display device displays an image using light emitting elements each including a light emitting layer made of an organic light emitting material. As the organic light emitting display device implements image display using self-light emitting elements, the organic light emitting display device may have relatively superior performance in terms of power consumption, response speed, emission efficiency, luminance, and wide viewing angle compared to other display devices.

A surface of the display device may be a display surface including a display area where an image is displayed and a non-display area surrounding the display area. Light emitting areas that emit light having respective luminance and color may be arranged in the display area.

### SUMMARY

The display device may include light emitting elements disposed in light emitting areas, and light emitting pixel drivers electrically connected to the light emitting elements.

Each of the light emitting pixel drivers may include a first transistor that generates a driving current for the light emitting element.

For example, in order for the first transistors of the light emitting pixel drivers to generate the driving current under the same conditions even during high-speed driving, each of the light emitting pixel drivers may further include a circuit that compensates for a potential of a gate electrode of the first transistor.

However, for uniformity of the first transistors, since power for compensating for the potential of the gate electrode of the first transistor needs to be supplied uniformly throughout the display area, the power for compensating for the potential of the gate electrode of the first transistor needs to be transmitted through a mesh-shaped line. Therefore, in the case that separate power for compensating for the potential of the gate electrode of the first transistor is transmitted to the light emitting pixel drivers, this may be disadvantageous in increasing a resolution of the display device.

Aspects of the disclosure provide a display device that is relatively advantageous in increasing a resolution while transmitting separate power for compensating for a potential of a gate electrode of a first transistor to light emitting pixel drivers through a mesh-shaped line.

However, aspects of the disclosure are not restricted to the one set forth herein. The above and other aspects of the disclosure will become more apparent to one of ordinary skill in the art to which the disclosure pertains by referencing the detailed description of the disclosure given below.

According to an aspect of the disclosure, there is provided a display device may include a substrate; a circuit layer disposed on the substrate; and an element layer disposed on the circuit layer. The substrate may include a display area in which light emitting areas are arranged, and a non-display area disposed around the display area. The element layer may include light emitting elements disposed in the light emitting areas. The circuit layer may include a first power supply line and a second power supply line disposed in the non-display area and transmitting first power and second power for driving the light emitting elements, respectively; light emitting pixel drivers electrically connected to the light emitting elements and arranged to be parallel to each other in a first direction and a second direction; first power lines extending in the first direction and electrically connected between the first power supply line and the light emitting pixel drivers; second power lines extending in the first direction and transmitting a third power different from the first power and the second power to the light emitting pixel drivers; and mesh auxiliary lines extending in the second direction. The mesh auxiliary lines may include a first mesh auxiliary line electrically connected to the first power lines; and a second mesh auxiliary line electrically connected to the second power lines.

The circuit layer may further include data lines extending in the second direction and transmitting data signals to the light emitting pixel drivers. The data lines may be adjacent to the mesh auxiliary lines. Each of the light emitting elements may be electrically connected between each of the light emitting pixel drivers and the second power. Each of the light emitting pixel drivers may include a first transistor electrically connected between a first node and a second node; a first pixel capacitor electrically connected between a third node and a fourth node; a second transistor electrically connected between a corresponding data line of the data lines and the fourth node; a third transistor electrically connected between the second node and the third node; a fourth transistor electrically connected between a first initialization voltage line transmitting a first initialization voltage and the third node; a fifth transistor electrically connected between a corresponding second power line of the second power lines and the fourth node; and a second pixel capacitor electrically connected between a corresponding first power line of the first power lines and the fourth node. The first node may be electrically connected to a first electrode of the first transistor. The second node may be electrically connected to a second electrode of the first transistor. The third node may be electrically connected to a gate electrode of the first transistor.

Each of the light emitting pixel drivers may further include a sixth transistor electrically connected between the corresponding first power line and the first node; a seventh transistor electrically connected between the second node and a fifth node; an eighth transistor electrically connected between a bias voltage line transmitting a bias voltage and the first node; and a ninth transistor electrically connected between a second initialization voltage line transmitting a second initialization voltage and the fifth node. The fifth node may be electrically connected to each of the light emitting elements.

The second transistor may be turned on by a scan write signal of a scan write line. The third transistor and the fifth transistor may be turned on by a gate control signal of a gate control line. The fourth transistor may be turned on by a scan initialization signal of a scan initialization line. The sixth transistor may be turned on by a first emission control signal of a first emission control line. The seventh transistor may be turned on by a second emission control signal of a second emission control line. The eighth transistor and the ninth transistor may be turned on by a bias control signal of a bias control line.

The first power lines and the second power lines may be arranged to alternate with each other in the second direction. Each of the light emitting pixel drivers may overlap the corresponding first power line and the corresponding second power line.

The mesh auxiliary lines may be disposed on one or more insulating layers covering the first power lines and one or more insulating layers covering the second power lines.

The circuit layer may further include a third power supply line disposed in the non-display area and transmitting the third power. Each of the second power lines and the second mesh auxiliary line may extend into the non-display area and may be electrically connected to the third power supply line.

The light emitting pixel drivers may include a first light emitting pixel driver, a second light emitting pixel driver, a third light emitting pixel driver, and a fourth light emitting pixel driver that are adjacent to each other in the first direction. The first mesh auxiliary line may be disposed adjacent to a boundary between the first light emitting pixel driver and the second light emitting pixel driver. The second mesh auxiliary line may be disposed adjacent to a boundary between the third light emitting pixel driver and the fourth light emitting pixel driver. The corresponding first power line and the corresponding second power line overlap the first light emitting pixel driver, the second light emitting pixel driver, the third light emitting pixel driver, and the fourth light emitting pixel driver. The corresponding first power line may be electrically connected to the first mesh auxiliary line through a first mesh connection hole. The corresponding second power line may be electrically connected to the second mesh auxiliary line through a second mesh connection hole. The first mesh connection hole may overlap the first light emitting pixel driver or the second light emitting pixel driver. The second mesh connection hole may overlap the third light emitting pixel driver or the fourth light emitting pixel driver.

The light emitting pixel drivers may include a first light emitting pixel driver and a second light emitting pixel driver that are adjacent to each other in the first direction. The first mesh auxiliary line may be adjacent to a boundary between the first light emitting pixel driver and the second light emitting pixel driver, and may overlap the first light emitting pixel driver. The second mesh auxiliary line may be adjacent to the boundary between the first light emitting pixel driver and the second light emitting pixel driver, and may overlap the second light emitting pixel driver. The corresponding first power line and the corresponding second power line overlap the first light emitting pixel driver and the second light emitting pixel driver. The corresponding first power line may be electrically connected to the first mesh auxiliary line through a first mesh connection hole. The corresponding second power line may be electrically connected to the second mesh auxiliary line through a second mesh connection hole. The first mesh connection hole may overlap the first light emitting pixel driver. The second mesh connection hole may overlap the second light emitting pixel driver.

The light emitting areas may include first light emitting areas emitting light of a first color; second light emitting areas emitting light of a second color in a lower wavelength band than the first color; and third light emitting areas emitting light of a third color in a lower wavelength band than the second color. The first light emitting areas and the third light emitting areas may be arranged to alternate with each other in the second direction. The second light emitting areas may be arranged to be parallel to each other in the second direction. The first light emitting pixel driver may be electrically connected to a light emitting element of one of the first light emitting areas and the third light emitting areas. The second light emitting pixel driver may be electrically connected to a light emitting element of the second light emitting areas.

The circuit layer may include a semiconductor layer disposed on the substrate; a first gate insulating layer covering the semiconductor layer; a first gate conductive layer disposed on the first gate insulating layer; a second gate insulating layer covering the first gate conductive layer; a second gate conductive layer disposed on the second gate insulating layer; a third gate insulating layer covering the second gate conductive layer; a third gate conductive layer disposed on the third gate insulating layer; an interlayer insulating layer covering the third gate conductive layer; a first source-drain conductive layer disposed on the interlayer insulating layer; a first planarization layer covering the first source-drain conductive layer; a second source-drain conductive layer disposed on the first planarization layer; and a second planarization layer covering the second source-drain conductive layer. The first power lines may be formed as the third gate conductive layer. The second power lines may be formed as the first source-drain conductive layer. The mesh auxiliary lines may be formed as the second source-drain conductive layer.

The circuit layer may further include a capacitor electrode formed as the second gate conductive layer and electrically connected to the fourth node. The gate electrode of the first transistor may be formed as the first gate conductive layer. The first pixel capacitor may be formed between the capacitor electrode and the gate electrode of the first transistor. The second pixel capacitor may be formed between the capacitor electrode and the first power line.

Each of the first mesh auxiliary line and the second mesh auxiliary line may include a main line portion extending in the second direction and a sub-protruding portion protruding from the main line portion. The circuit layer may further include a power connection electrode overlapping the sub-protruding portion of the first mesh auxiliary line and the first mesh connection hole. The power connection electrode may be electrically connected to the first mesh auxiliary line through a first mesh auxiliary connection hole, and may be electrically connected to the corresponding first power line through a second mesh auxiliary connection hole. The first mesh connection hole may include the first mesh auxiliary connection hole and the second mesh auxiliary connection hole. The sub-protruding portion of the second mesh auxiliary line may overlap a portion of the corresponding second power line and the second mesh connection hole.

The main line portion of the first mesh auxiliary line and the main line portion of the second mesh auxiliary line may be symmetrical to each other based on the boundary between the first light emitting pixel driver and the second light emitting pixel driver.

According to an aspect of the disclosure, there is provided a display device may include a substrate; a circuit layer disposed on the substrate; and an element layer disposed on the circuit layer. The substrate may include a display area in which light emitting areas are arranged, and a non-display area disposed around the display area. The element layer may include light emitting elements disposed in the light emitting areas. The circuit layer may include a first power supply line and a second power supply line disposed in the non-display area and transmitting first power and second power for driving the light emitting elements, respectively; a third power supply line disposed in the non-display area and transmitting a third power; light emitting pixel drivers electrically connected to the light emitting elements and arranged to be parallel to each other in a first direction and a second direction; first power lines extending in the first direction and electrically connected between the first power supply line and the light emitting pixel drivers; second power lines extending in the first direction and transmitting a third power different from the first power and the second power to the light emitting pixel drivers; and mesh auxiliary lines extending in the second direction. The mesh auxiliary lines may include first mesh auxiliary lines electrically connected to the first power lines; and second mesh auxiliary lines electrically connected to the second power lines. The first mesh auxiliary lines and the second mesh auxiliary lines may be arranged to alternate with each other in the first direction. The first power lines and the second power lines may be arranged to alternate with each other in the second direction. Each of the light emitting pixel drivers may overlap a corresponding first power line and a corresponding second power line. Each of the second power lines and the second mesh auxiliary line may extend into the non-display area and may be electrically connected to the third power supply line.

The circuit layer may further include data lines extending in the second direction and transmitting data signals to the light emitting pixel drivers. The data lines may be adjacent to the mesh auxiliary lines. Each of the light emitting elements may be electrically connected between each of the light emitting pixel drivers and the second power. Each of the light emitting pixel drivers may include a first transistor electrically connected between a first node and a second node; a first pixel capacitor electrically connected between a third node and a fourth node; a second transistor electrically connected between a corresponding data line of the data lines and the fourth node; a third transistor electrically connected between the second node and the third node; a fourth transistor electrically connected between a first initialization voltage line transmitting a first initialization voltage and the third node; a fifth transistor electrically connected between a corresponding second power line of the second power lines and the fourth node; and a second pixel capacitor electrically connected between a corresponding first power line of the first power lines and the fourth node. The first node may be electrically connected to a first electrode of the first transistor. The second node may be electrically connected to a second electrode of the first transistor. The third node may be electrically connected to a gate electrode of the first transistor.

The light emitting pixel drivers may include a first light emitting pixel driver, a second light emitting pixel driver, a third light emitting pixel driver, and a fourth light emitting pixel driver that are adjacent to each other in the first direction. Each of the first mesh auxiliary lines may be disposed adjacent to a boundary between the first light emitting pixel driver and the second light emitting pixel driver. Each of the second mesh auxiliary lines may be disposed adjacent to a boundary between the third light emitting pixel driver and the fourth light emitting pixel driver. The corresponding first power line and the corresponding second power line may overlap the first light emitting pixel driver, the second light emitting pixel driver, the third light emitting pixel driver, and the fourth light emitting pixel driver,

The light emitting pixel drivers may include a first light emitting pixel driver and a second light emitting pixel driver that are adjacent to each other in the first direction. Each of the first mesh auxiliary lines may be adjacent to a boundary between the first light emitting pixel driver and the second light emitting pixel driver, and may overlap the first light emitting pixel driver. Each of the second mesh auxiliary lines may be adjacent to the boundary between the first light emitting pixel driver and the second light emitting pixel driver, and may overlap the second light emitting pixel driver. The corresponding first power line and the corresponding second power line overlap the first light emitting pixel driver and the second light emitting pixel driver.

The light emitting areas may include first light emitting areas emitting light of a first color; second light emitting areas emitting light of a second color in a lower wavelength band than the first color; and third light emitting areas emitting light of a third color in a lower wavelength band than the second color. The first light emitting areas and the third light emitting areas may be arranged to alternate with each other in the second direction. The second light emitting areas may be arranged to be parallel to each other in the second direction. The first light emitting pixel driver may be electrically connected to a light emitting element of one of the first light emitting areas and the third light emitting areas. The second light emitting pixel driver may be electrically connected to a light emitting element of the second light emitting areas.

Each of the first mesh auxiliary lines and the second mesh auxiliary lines may include a main line portion extending in the second direction and a sub-protruding portion protruding from the main line portion. The circuit layer may further include a power connection electrode overlapping the sub-protruding portion of a corresponding first mesh auxiliary line and the first mesh connection hole. The power connection electrode may be electrically connected to a corresponding first mesh auxiliary line through a first connection hole, and may be electrically connected to the corresponding first power line through a second connection hole. The first mesh connection hole may include the first connection hole and the second connection hole. The sub-protruding portion of the corresponding second mesh auxiliary line may overlap a portion of the corresponding second power line and the second mesh connection hole. The main line portion of a corresponding first mesh auxiliary line and the main line portion of a corresponding second mesh auxiliary line may be symmetrical to each other based on the boundary between the first light emitting pixel driver and the second light emitting pixel driver.

The display device according to embodiments may include a substrate, a circuit layer, and an element layer.

The element layer may include light emitting elements respectively disposed in light emitting areas arranged in a display area of the substrate.

The circuit layer may include a first power supply line and a second power supply line disposed in a non-display area of the substrate and respectively transmitting a first power and a second power for driving the light emitting elements, light emitting pixel drivers each electrically connected to the light emitting elements and arranged in a first direction and a second direction, first power lines extending in the first direction and electrically connected between the first power supply line and the light emitting pixel drivers, a second power line extending in the first direction and transmitting a third power different from the first power and the second power to the light emitting pixel drivers, and mesh auxiliary lines extending in the second direction.

The mesh auxiliary lines may include first mesh auxiliary lines electrically connected to the first power lines, and second mesh auxiliary lines electrically connected to the second power lines.

According to embodiments, one of the light emitting pixel drivers may include a first transistor between a first node and a second node, a first pixel capacitor between a third node and a fourth node, a second transistor between a data line and the fourth node, a third transistor between the second node and the third node, a fourth transistor between a first initialization voltage line and the third node, a fifth transistor between a second power line and the fourth node, and a second pixel capacitor between a first power line and the fourth node. The first node may correspond to a first electrode of the first transistor, the second node may correspond to a second electrode of the first transistor, and the third node may correspond to a gate electrode of the first transistor.

As such, according to embodiments, in the case that the fifth transistor is turned on, a potential of the third node, e.g., the gate electrode of the first transistor, may be compensated by the third power. For example, each light emitting pixel driver may include the fifth transistor as a circuit that compensates for the potential of the gate electrode of the first transistor.

Here, since the compensation of the potential of the gate electrode of the first transistor may be performed based on the third power, not the first power, the first power may be used only to generate the driving current for the light emitting element. Therefore, unlike the first power for generating the driving current, since the third power is not used to generate the current, the compensation of the potential of the gate electrode of the first transistor may be more stably performed. As a result, high-speed driving of the display device may become more advantageous, and an image quality of the display device may be improved.

For example, according to embodiments, the first mesh auxiliary lines, which are some of the mesh auxiliary lines adjacent to the data lines, may transmit the first power, and the second mesh auxiliary lines, which are other remaining portions, may transmit a separate third power that is different from the first power and the second power.

As the first power lines in the first direction are electrically connected to the first mesh auxiliary lines in the second direction, the first power may be applied to the light emitting pixel drivers through a mesh-shaped line.

As well, as the second power lines in the first direction are electrically connected to the second mesh auxiliary lines in the second direction, the third power may also be applied to the light emitting pixel drivers through a mesh-shaped line.

Therefore, since the separate third power for compensation of the potential of the gate electrode of the first transistor may be applied to the light emitting pixel drivers through the mesh-shaped line without adding a separate line, it may be advantageous in increasing a resolution.

However, effects according to the embodiments are not limited to those examples above and various other effects are incorporated herein.

### BRIEF DESCRIPTION OF THE DRAWINGS

The above and other aspects and features of the disclosure will become more apparent by describing in detail embodiments thereof with reference to the attached drawings, in which:
FIG. 1 is a schematic perspective view illustrating a display device;
FIG. 2 is a schematic plan view illustrating the display device of FIG. 1;
FIG. 3 is a schematic cross-sectional view taken along line A-A' of FIG. 2;
FIG. 4 is a layout view illustrating a portion B of FIG. 2;
FIG. 5 is a schematic diagram of an equivalent circuit of a light emitting pixel driver of FIG. 4;
FIG. 6 is a schematic plan view illustrating a substrate and a circuit layer of FIG. 2;
FIG. 7 is a layout view illustrating a portion C of FIG. 6;
FIG. 8 is a schematic plan view illustrating a portion D of FIG. 7;
FIG. 9 is a layout view illustrating a portion C of FIG. 6;
FIG. 10 is a schematic plan view illustrating a portion D of FIG. 9;
FIG. 11 is a schematic plan view illustrating a portion F of FIG. 10;
FIG. 12 is a schematic plan view illustrating a semiconductor layer, a first gate conductive layer, and a second gate conductive layer in the plan view of FIG. 11;
FIG. 13 is a schematic plan view illustrating a semiconductor layer, a first gate conductive layer, a second gate conductive layer, and a third gate conductive layer in the plan view of FIG. 11;
FIG. 14 is a schematic plan view illustrating a semiconductor layer, a first gate conductive layer, a second gate conductive layer, a third gate conductive layer, and a first source drain conductive layer in the plan view of FIG. 11;
FIG. 15 is a schematic cross-sectional view taken along line G-G' of FIG. 11; and
FIG. 16 is a schematic cross-sectional view taken along line H-H' of FIG. 11.

### DETAILED DESCRIPTION OF THE EMBODIMENTS

In the following description, for the purposes of explanation, numerous specific details are set forth in order to provide a thorough understanding of various embodiments or implementations of the invention. As used herein, "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the scope of the invention.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals denote like elements.

When an element or a layer is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the axis of the first direction DR1, the axis of the second direction DR2, and the axis of the third direction DR3 are not limited to three axes of a rectangular coordinate system, such as the X, Y, and Z - axes, and may be interpreted in a broader sense. For example, the axis of the first direction DR1, the axis of the second direction DR2, and the axis of the third direction DR3 may be perpendicular to one another, or may represent different directions that are not perpendicular to one another. For the purposes of this disclosure, "at least one of A and B" may be understood to mean A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one element's relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein should be interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

As customary in the field, some embodiments are described and illustrated in the accompanying drawings in terms of functional blocks, units, and/or modules. Those skilled in the art will appreciate that these blocks, units, and/or modules are physically implemented by electronic (or optical) circuits, such as logic circuits, discrete components, microprocessors, hard-wired circuits, memory elements, wiring connections, and the like, which may be formed using semiconductor-based fabrication techniques or other manufacturing technologies. In the case of the blocks, units, and/or modules being implemented by microprocessors or other similar hardware, they may be programmed and controlled using software (e.g., microcode) to perform various functions discussed herein and may optionally be driven by firmware and/or software. It is also contemplated that each block, unit, and/or module may be implemented by dedicated hardware, or as a combination of dedicated hardware to perform some functions and a processor (e.g., one or more programmed microprocessors and associated circuitry) to perform other functions. Also, each block, unit, and/or module of some embodiments may be physically separated into two or more interacting and discrete blocks, units, and/or modules without departing from the scope of the invention. Further, the blocks, units, and/or modules of some embodiments may be physically combined into more complex blocks, units, and/or modules without departing from the scope of the invention.

Hereinafter, specific embodiments will be described with reference to the accompanying drawings.

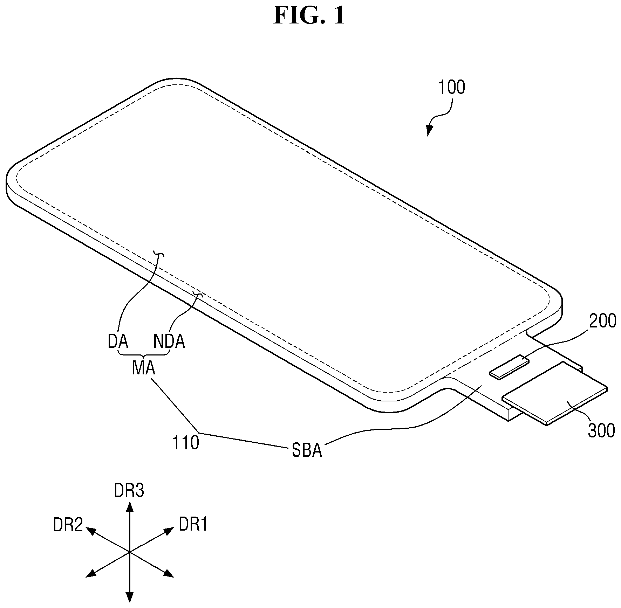

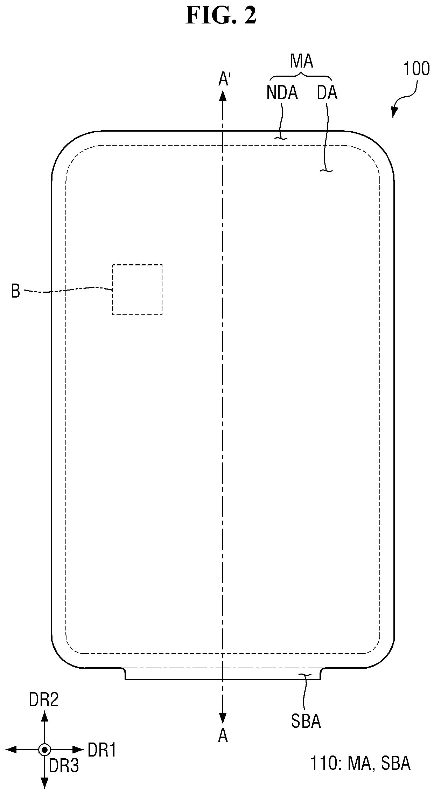

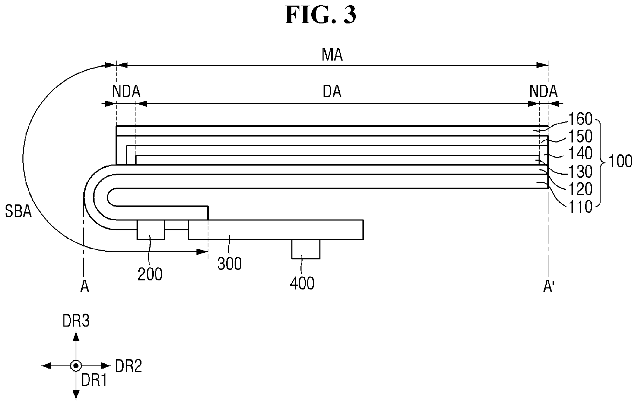

FIG. 1 is a schematic perspective view illustrating a display device. FIG. 2 is a schematic plan view illustrating the display device of FIG. 1. FIG. 3 is a schematic cross-sectional view taken along line A-A' of FIG. 2.

Referring to FIGS. 1 and 2, a display device 100 may be a device that displays a moving image or a still image, and may be used as a display screen of each of various products such as a television, a laptop computer, a monitor, a billboard, and an Internet of Things (IOT) device as well as portable electronic devices such as a mobile phone, a smartphone, a tablet personal computer (PC), a smartwatch, a watch phone, a mobile communication terminal, an electronic organizer, an electronic book, a portable multimedia player (PMP), a navigation device, and an ultra mobile PC (UMPC).

The display device 100 may be a light emitting display device such as an organic light emitting display device including an organic light emitting diode, a quantum dot light emitting display device including a quantum dot light emitting layer, an inorganic light emitting display device including an inorganic semiconductor, and a micro light emitting display device including a micro or nano light emitting diode (micro or nano LED). Hereinafter, the description will be made mainly based on the fact that the display device 100 is an organic light emitting display device. However, embodiments are not limited thereto and may be applied to display devices including organic insulating materials, organic light emitting materials, and metal materials.

The display device 100 may be formed to be flat, but is not limited thereto. For example, the display device 100 may include curved surface portions formed at left and right distal end portions thereof and having a constant curvature or a variable curvature. For example, the display device 100 may be flexibly formed to be curved, bent, folded, or rolled.

As illustrated in FIGS. 1, 2, and 3, the display device 100 includes a substrate 110.

The substrate 110 may include a main area MA corresponding to a display surface of the display device 100 and a sub-area SBA protruding from a side of the main area MA.

As illustrated in FIG. 2, the main area MA includes a display area DA disposed at most of the center portion and a non-display area NDA disposed around the display area DA.

The display area DA may be formed in a quadrangular plane having short sides extending in a first direction DR1 and long sides extending in a second direction DR2 intersecting the first direction DR1. A corner portion where the short side in the first direction DR1 and the long side in the second direction DR2 meet may be rounded to have a selected curvature or may be formed at a right angle. The planar shape of the display area DA is not limited to the quadrangular shape, and the display area DA may be formed in other polygonal, circular, or oval shapes different from the quadrangular shape.

The non-display area NDA may be disposed at an edge portion of the main area MA to surround the display area DA.

The sub-area SBA may be an area protruding from the non-display area NDA of the main area MA to a side in the second direction DR2.

As a portion of the sub-area SBA is deformed into a curved shape, another portion of the sub-area SBA may be disposed on a rear surface of the display device 100.

FIGS. 2 and 3 illustrate the display device 100 with a portion of the sub-area SBA curved.

Referring to FIG. 3, the display device 100 includes a substrate 110, a circuit layer 120 disposed on the substrate 110, and an element layer 130 disposed on the circuit layer 120.

The display device 100 may further include a sealing layer 140 disposed on the element layer 130, and a touch sensor layer 150 disposed on the sealing layer 140.

For example, the display device 100 may further include a polarizing layer 160 disposed on the touch sensor layer 150 to reduce or minimize reflection of external light.

The substrate 110 may be made of an insulating material such as a polymer resin. For example, the substrate 110 may be made of polyimide. The substrate 110 may be a flexible substrate that is bendable, foldable, and rollable.

In another example, the substrate 110 may be made of an insulating material such as glass.

The substrate 110 may include a main area MA and a sub-area SBA. The main area MA may include a display area DA and a non-display area NDA.

Referring to FIG. 3, a circuit board 300 may be connected (e.g., electrically connected) to the circuit layer 120 disposed on the substrate 110. A power supply unit 400 may be mounted on the circuit board 300. The power supply unit 400 may supply power supply voltages to the circuit layer 120 through the circuit board 300.

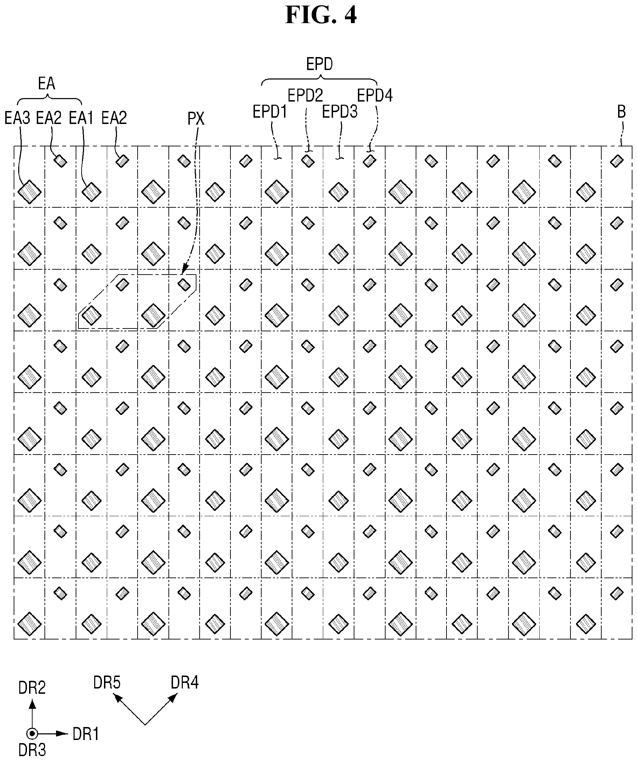

FIG. 4 is a layout view illustrating a portion B of FIG. 2.

Referring to FIG. 4, the display area DA of the display device 100 includes light emitting areas EA. For example, the display area DA may further include a non-light emitting area disposed in a spaced area between the light emitting areas EA.

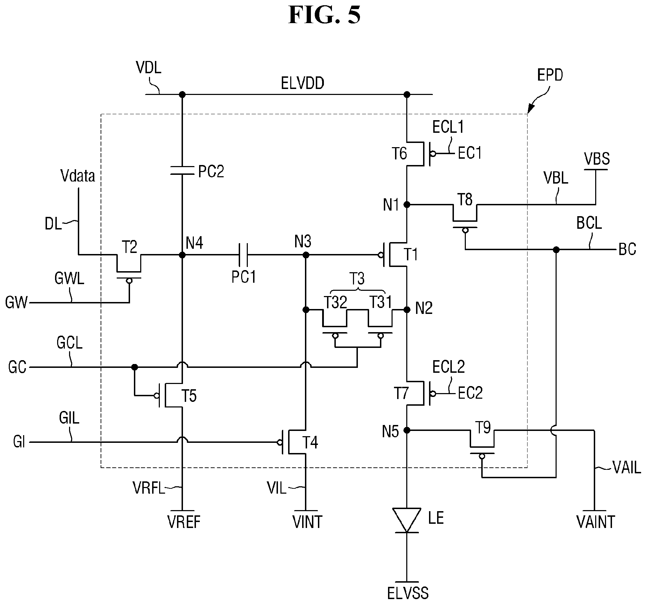

Light emitting pixel drivers EPD each corresponding to the light emitting areas EA may be arranged in the display area DA to be parallel to each other in the first direction DR1 and the second direction DR2. The light emitting pixel drivers EPD may be connected (e.g., electrically connected) to light emitting elements (e.g., LE in FIG. 5) of the element layer 130 each disposed in the light emitting areas EA.

The light emitting areas EA may have a rhombic planar shape or a rectangular planar shape. However, this is an example, and the planar shape of the light emitting areas EA is not limited to that illustrated in FIG. 4. For example, the light emitting areas EA may have a polygonal planar shape such as a square, pentagon, or hexagon, or a circular or oval planar shape including curved edge portions.

The light emitting areas EA may include first light emitting areas EA1 that emit light of a first color in a selected wavelength band, second light emitting areas EA2 that emit light of a second color in a wavelength band lower than that of the first color, and third light emitting areas EA3 that emit light of a third color in a wavelength band lower than that of the second color.

As an example, the first color may be red in a wavelength band of about 600 nm to about 750 nm. The second color may be green in a wavelength band of about 480 nm to about 560 nm. The third color may be blue in a wavelength band of about 370 nm to about 460 nm.

The first light emitting areas EA1 and the third light emitting areas EA3 may be arranged to alternate with each other in at least one of the first direction DR1 and the second direction DR2.

As an example, in the second direction DR2, the first light emitting areas EA1 may be arranged to be parallel to each other, and the third light emitting areas EA3 may be arranged to be parallel to each other. For example, in the first direction DR1, the first light emitting areas EA1 and the third light emitting areas EA3 may be arranged to alternate with each other.

The second light emitting areas EA2 may be arranged to be parallel to each other in at least one of the first direction DR1 and the second direction DR2.

For example, the second light emitting areas EA2 may be adjacent to the first light emitting areas EA1 and the third light emitting areas EA3 in diagonal directions DR4 and DR5 intersecting the first and second directions DR1 and DR2.

As an example, the second light emitting areas EA2 may be arranged to be parallel to each other in each of the first direction DR1 and the second direction DR2, but may not be parallel to the first light emitting areas EA1 and the third light emitting areas EA3.

The light emitting pixel drivers EPD may include a first light emitting pixel driver EPD1 and a second light emitting pixel driver EPD2 arranged to be parallel to each other in the first direction DR1. For example, the light emitting pixel drivers EPD may further include a third light emitting pixel driver EPD3 and a fourth light emitting pixel driver EPD4 arranged to be parallel to the first light emitting pixel driver EPD1 and the second light emitting pixel driver EPD2 in the first direction DR1.

As the light emitting areas EA include the first light emitting areas EA1, the second light emitting areas EA2, and the third light emitting areas EA3, each of the first light emitting pixel driver EPD1 and the third light emitting pixel driver EPD3 may be connected (e.g., electrically connected) to one of light emitting elements of the first light emitting area EA1 and the third light emitting area EA3. For example, each of the second light emitting pixel driver EPD2 and the fourth light emitting pixel driver EPD4 may be connected (e.g., electrically connected) to a light emitting element in the second light emitting area EA2.

Further, as the light emitting areas EA include the first light emitting areas EA1, the second light emitting areas EA2, and the third light emitting areas EA3, pixels PX that display each luminance and color may be provided by one or more first light emitting areas EA1, one or more second light emitting areas EA2, and one or more third light emitting areas EA3 that are adjacent to each other among the light emitting areas EA.

For example, the pixels PX may be basic units that display various colors, including white, at selected luminance.

Each of the pixels PX may include one or more first light emitting areas EA1, one or more second light emitting areas EA2, and one or more third light emitting areas EA3 adjacent to each other. As an example, each of the pixels PX may include a single first light emitting area EA1 and a single third light emitting area EA3 adjacent to each other in the first direction DR1, and two second light emitting areas EA2 adjacent to the single first light emitting area EA1 and the single third light emitting area EA3 in the fourth direction DR4. Accordingly, each of the pixels PX may display various colors through mixing of light emitted from the first, second, and third light emitting areas EA1, EA2, and EA3 adjacent to each other.

FIG. 5 is a schematic diagram of an equivalent circuit of a light emitting pixel driver of FIG. 4.

Referring to FIG. 5, one of the light emitting elements LE of the element layer 130 may be connected (e.g., electrically connected) between one of the light emitting pixel drivers EPD of the circuit layer 120 and a second power ELVSS.

For example, a first power (voltage) ELVDD may be applied to the light emitting pixel driver EPD, an anode electrode of the light emitting element LE may be connected (e.g., electrically connected) to the light emitting pixel driver EPD, and a second power (voltage) ELVSS having a lower voltage level than the first power ELVDD may be applied to a cathode electrode of the light emitting element LE. Accordingly, the driving current between the first power ELVDD and the second power ELVSS may be supplied to the light emitting element LE by the light emitting pixel driver EPD.

The circuit layer 120 may further include a data line DL transmitting a data signal Vdata, a first power line VDL transmitting the first power ELVDD, a first initialization voltage line VIL transmitting a first initialization voltage VINT, a second initialization voltage line VAIL transmitting a second initialization voltage VAINT, a second power line VRFL transmitting a third power VREF different from the first power ELVDD and the second power ELVSS, and a bias voltage line VBL transmitting a bias voltage VBS.

The circuit layer 120 may further include a scan write line GWL transmitting a scan write signal GW, a scan initialization line GIL transmitting a scan initialization signal GI, a gate control line GCL transmitting a gate control signal GC, a first emission control line ECL1 transmitting a first emission control signal EC1, a second emission control line ECL2 transmitting a second emission control signal EC2, and a bias control line BCL transmitting a bias control signal BC.

One of the light emitting pixel drivers EPD of the circuit layer 120 may include a first transistor T1 that generates a driving current for driving a light emitting element LE, two or more transistors T2 to T9 connected (e.g., electrically connected) to the first transistor T1, and one or more pixel capacitors PC1 and PC2.

For example, the light emitting pixel driver EPD may include a first transistor T1 connected (e.g., electrically connected) between the first node N1 and the second node N2, a first pixel capacitor PC1 connected (e.g., electrically connected) between the third node N3 and the fourth node N4, a second transistor T2 connected (e.g., electrically connected) between the data line DL and the fourth node N4, a third transistor T3 connected (e.g., electrically connected) between the second node N2 and the third node N3, a fourth transistor T4 connected (e.g., electrically connected) between the first initialization voltage line VIL and the third node N3, and a fifth transistor T5 connected (e.g., electrically connected) between the second power line VRFL and the fourth node N4.

The first node N1 may be connected (e.g., electrically connected) to a first electrode (e.g., source electrode) of the first transistor T1. The second node N2 may be connected (e.g., electrically connected) to a second electrode (e.g., drain electrode) of the first transistor T1. The third node N3 may be connected (e.g., electrically connected) to a gate electrode of the first transistor T1.

A light emitting pixel driver EPD may further include a sixth transistor T6 connected (e.g., electrically connected) between the first power line VDL and the first node N1, a seventh transistor T7 connected (e.g., electrically connected) between the second node N2 and a fifth node N5, an eighth transistor T8 connected (e.g., electrically connected) between the bias voltage line VBL and the first node N1, and a ninth transistor T9 connected (e.g., electrically connected) between the second initialization voltage line VAIL and the fifth node N5.

The fifth node N5 may be connected (e.g., electrically connected) to a light emitting element LE.

The fourth transistor T4 may be turned on by the scan initialization signal GI of the scan initialization line GIL.

Accordingly, a potential of the third node N3 may be initialized to the first initialization voltage VINT through the turned-on fourth transistor T4.

The third transistor T3 and the fifth transistor T5 may be turned on by the gate control signal GC of the gate control line GCL.

Accordingly, a voltage difference between the second node N2 and the third node N3 may be reset through the turned-on third transistor T3. For example, a voltage difference between the gate electrode of the first transistor T1 and the second electrode of the first transistor T1 may be reset (or initialized).

For example, the third power (voltage) VREF may be applied to the fourth node N4 through the turned-on fifth transistor T5. Accordingly, as a charging voltage of the first pixel capacitor PC1 connected to the fourth node N4 changes based on the third power VREF, a potential of the gate electrode of the first transistor T1 connected to the first pixel capacitor PC1 may also be compensated based on the third power VREF.

The second transistor T2 may be turned on by the scan write signal GW of the scan write line GWL.

Accordingly, the data signal Vdata of the data line DL may be transmitted to the first pixel capacitor PC1 connected to the fourth node N4 through the turned-on second transistor T2.

For example, the first pixel capacitor PC1 between the third node N3 and the fourth node N4 may be charged to a voltage level corresponding to a differential voltage (VREF-Vdata) between the third power VREF and the data signal Vdata.

In the case that a voltage difference between the gate electrode of the first transistor T1 and the first electrode of the first transistor T1, e.g., a gate-source voltage difference becomes a threshold voltage or more due to the voltage charged in the first pixel capacitor PC1, the first transistor T1 may be turned on. In the case that the first transistor T1 is turned on, a drain-source current may be generated between the first electrode of the first transistor T1 and the second electrode of the first transistor T1, and may have a magnitude corresponding to the data signal Vdata. For example, a driving current having a magnitude corresponding to the data signal Vdata may be generated between the first node N1 and the second node N2 through the turned-on first transistor T1.

The eighth transistor T8 and the ninth transistor T9 may be turned on by the bias control signal BC of the bias control line BCL.

Accordingly, a potential of the first electrode of the first transistor T1 connected to the first node N1 may be reset to the bias voltage VBS through the turned-on eighth transistor T8.

For example, a potential of the anode electrode of the light emitting element LE connected to the fifth node N5 may be initialized to the second initialization voltage VAINT through the turned-on ninth transistor T9.

The sixth transistor T6 may be turned on by the first emission control signal EC1 of the first emission control line ECL1.

The seventh transistor T7 may be turned on by the second emission control signal EC2 of the second emission control line ECL2.

Since the first transistor T1 and the light emitting element LE are connected in series with each other between the first power ELVDD and the second power ELVSS through the turned-on sixth transistor T6 and the turned-on seventh transistor T7, the drain-source current of the first transistor T1 may be supplied as the driving current of the light emitting element LE.

Accordingly, the light emitting element LE may emit light having luminance corresponding to the data signal Vdata.

The third transistor T3 may include a plurality of sub-transistors connected in series. As an example, the third transistor T3 may include a first sub-transistor T31 and a second sub-transistor T32. For example, the potential of the gate electrode of the first transistor T1 may be prevented from being changed due to leakage current caused by a turned-off third transistor T3.

As illustrated in FIG. 5, the transistors T1 to T9 of each of the light emitting pixel drivers EPD may be provided (or formed) as P-type MOSFETs. However, this is only an example, and at least some of the transistors T1 to T9 of each of the light emitting pixel drivers EPD may also be provided (or formed) as N-type MOSFETs.

As described above, the light emitting pixel driver EPD may include a compensation circuit including the fifth transistor T5 to compensate for the potential of the gate electrode of the first transistor T1. For example, the potential of the gate electrode of the first transistor T1 may be compensated by the third power VREF through the turned-on fifth transistor T5.

Accordingly, the compensation of the potential of the gate electrode of the first transistor T1 may be performed using a separate third power VREF rather than the first power ELVDD. As a result, since the compensation of the potential of the gate electrode of the first transistor T1 is more stably performed, high-speed driving of the display device 100 may be more advantageous and image quality thereof may be improved.

In order to improve the uniformity of driving characteristics of the first transistors T1 of all light emitting pixel drivers EPD, the third power VREF for compensating for the potential of the gate electrode of the first transistor T1 may need to be supplied to the display area DA through a mesh-shaped line including lines in the first direction DR1 and lines in the second direction DR2.

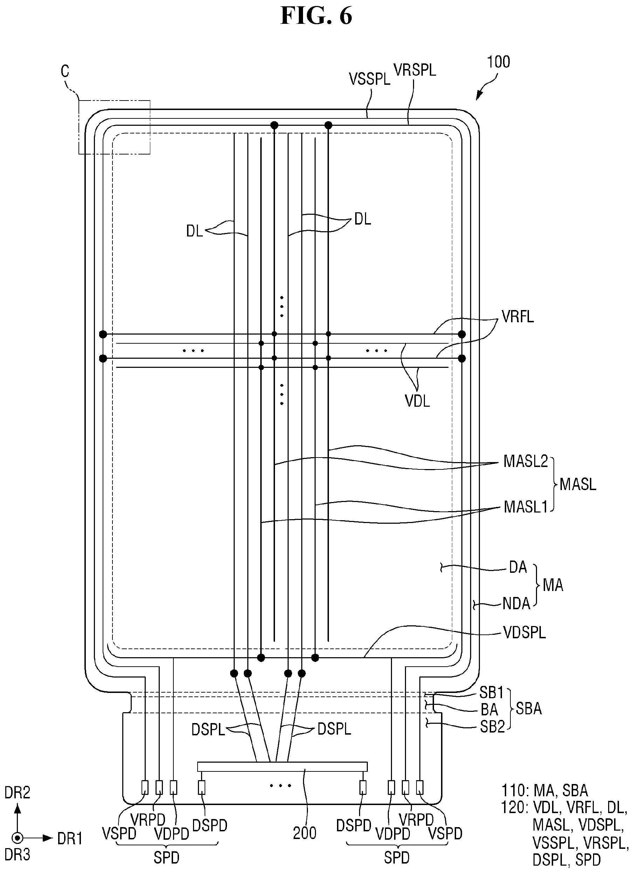

FIG. 6 is a schematic plan view illustrating a substrate and a circuit layer of FIG. 2.

Referring to FIG. 6, the display device 100 includes a substrate 110 and a circuit layer 120 disposed on the substrate 110.

The substrate 110 may include a main area MA corresponding to a display surface and a sub-area SBA protruding from a side of the main area MA.

The main area MA may include a display area DA disposed in the center portion, and a non-display area NDA surrounding the display area DA.

The display area DA may include light emitting areas (e.g., EA in FIG. 4).

The sub-area SBA may include a bending area BA that is deformed into a bent shape, a first sub-area SB1 disposed between a side of the bending area BA and the main area MA, and a second sub-area SB2 connected to another side of the bending area BA.

In case that the bending area BA is deformed into the bent shape, the second sub-area SB2 may be disposed below the substrate 110 and may overlap the main area MA.

A display driving circuit 200 may be disposed in the second sub-area SB2.

The circuit layer 120 may include a first power supply line VDSPL and a second power supply line VSSPL disposed in the non-display area NDA and respectively transmitting the first power (e.g., ELVDD in FIG. 5) and the second power (e.g., ELVSS in FIG. 5) for driving the light emitting elements (e.g., LE in FIG. 5), light emitting pixel drivers (e.g., EPD in FIGS. 4 and 5) connected (e.g., electrically connected) to the light emitting elements (e.g., LE in FIG. 5) of the light emitting areas (e.g., EA in FIG. 4) and arranged to be parallel to each other in the first direction DR1 and the second direction DR2, first power lines VDL extending in the first direction DR1 and connected (e.g., electrically connected) between the first power supply line VDSPL and the light emitting pixel drivers (e.g., EPD in FIGS. 4 and 5), second power lines VRFL extending in the first direction DR1 and transmitting the third power (e.g., VREF in FIG. 5) different from the first power (e.g., ELVDD in FIG. 5) and the second power (e.g., ELVSS in FIG. 5) to the light emitting pixel drivers (e.g., EPD in FIGS. 4 and 5), and mesh auxiliary lines MASL extending in the second direction DR2.

The mesh auxiliary lines MASL may include first mesh auxiliary lines MASL1 connected (e.g., electrically connected) to the first power lines VDL, and second mesh auxiliary lines MASL2 connected (e.g., electrically connected) to the second power lines VRFL.

The circuit layer 120 may further include data lines DL extending in the second direction DR2 and transmitting the data signal (e.g., Vdata in FIG. 5) to the light emitting pixel drivers (e.g., EPD in FIGS. 4 and 5).

The data lines DL may be adjacent to the mesh auxiliary lines MASL.

The first power lines VDL and the second power lines VRFL may be arranged to alternate with each other in the second direction DR2.

For example, the first mesh auxiliary lines MASL1 and the second mesh auxiliary lines MASL2 may be arranged to alternate with each other in the first direction DR1.

As the first mesh auxiliary lines MASL1 of the mesh auxiliary lines MASL in the second direction DR2 are connected (e.g., electrically connected) to the first power lines VDL in the first direction DR1, the first power (e.g., ELVDD in FIG. 5) for generating the driving current may be supplied to the entire display area DA through a mesh-shaped line including the first power lines VDL in the first direction DR1 and the first mesh auxiliary lines MASL1 in the second direction DR2. As a result, a first power (e.g., ELVDD in FIG. 5) at a stable voltage level may be applied to the light emitting pixel drivers (e.g., EPD in FIGS. 4 and 5) throughout the display area DA.

As well, as the second mesh auxiliary lines MASL2 of the mesh auxiliary lines MASL in the second direction DR2 are connected (e.g., electrically connected) to the second power lines VRFL in the first direction DR1, the third power (e.g., VREF in FIG. 5) for compensating for the potential of the gate electrode of the first transistor (e.g., T1 in FIG. 5) may also be supplied to the entire display area DA through a mesh-shaped line including the second power lines VRFL in the first direction DR1 and the second mesh auxiliary lines MASL2 in the second direction DR2. As a result, a third power (e.g., VREF in FIG. 5) at a stable voltage level may be applied to the light emitting pixel drivers (e.g., EPD in FIGS. 4 and 5) throughout the display area DA.

Therefore, since the third power (e.g., VREF in FIG. 5) different from the first power (e.g., ELVDD in FIG. 5) and the second power (e.g., ELVSS in FIG. 5) may be applied to the light emitting pixel drivers (e.g., EPD in FIGS. 4 and 5) throughout the display area DA through the mesh-shaped line, it is advantageous in increasing a resolution of the display device 100.

The circuit layer 120 may further include a third power supply line VRSPL disposed in the non-display area NDA and transmitting the third power (e.g., VREF in FIG. 5).

For example, the circuit layer 120 may further include supply pads SPD disposed at an edge portion of the second sub-area SB2.

The circuit board (300 in FIGS. 1 and 3) may be bonded to the supply pads SPD and connected (e.g., electrically connected) to the circuit layer 120 and the display driving circuit 200.

The supply pads SPD may include data supply pads DSPD connected (e.g., electrically connected) to the display driving circuit 200, a first power supply pad VDPD connected (e.g., electrically connected) to the first power supply line VDSPL, a second power supply pad VSPD connected (e.g., electrically connected) to the second power supply line VSSPL, and a third power supply pad VRPD connected (e.g., electrically connected) to the third power supply line VRSPL.

The first power supply line VDSPL may be disposed to be parallel to a side of an edge portion of the display area DA facing the sub-area SBA, and extend to the first power supply pad VDPD of the sub-area SBA.

The second power supply line VSSPL may be disposed to be parallel to the remaining sides except for a side of the edge portion of the display area DA facing the sub-area SBA, and extend to the second power supply pad VSPD of the sub-area SBA.

The third power supply line VRSPL may be disposed to be parallel to the remaining sides except for a side of the edge portion of the display area DA facing the sub-area SBA, and extend to the third power supply pad VRPD of the sub-area SBA.

The second power supply line VSSPL may be disposed between an edge portion of the substrate 110 and the third power supply line VRSPL. For example, the third power supply line VRSPL may be disposed between the second power supply line VSSPL and the edge portion of the display area DA. However, this is only an example, and the arrangement and shape of each of the first power supply line VDSPL, the second power supply line VSSPL, and the third power supply line VRSPL may be changed as much as desired.

The circuit layer 120 may further include data supply lines DSPL disposed in the non-display area NDA, extending to the display driving circuit 200 of the sub-area SBA, and connected (e.g., electrically connected) to the data lines DL.

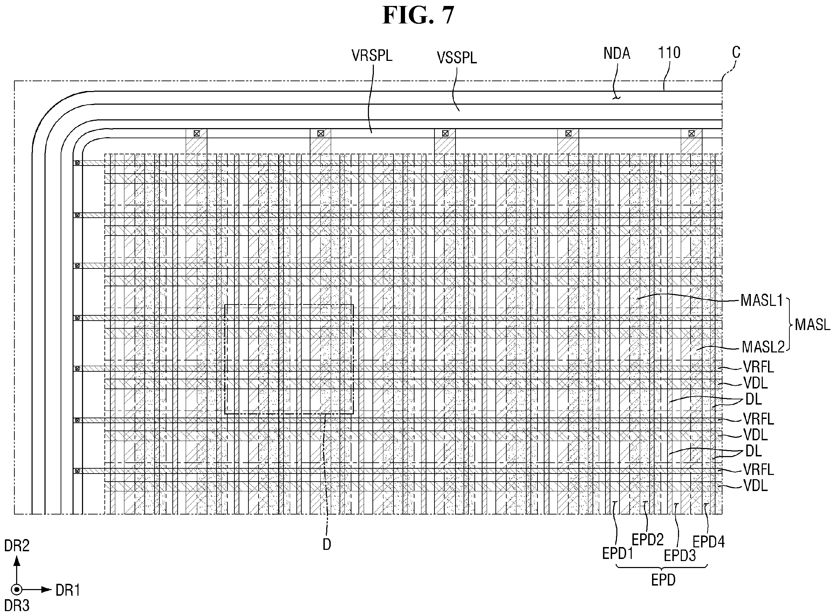

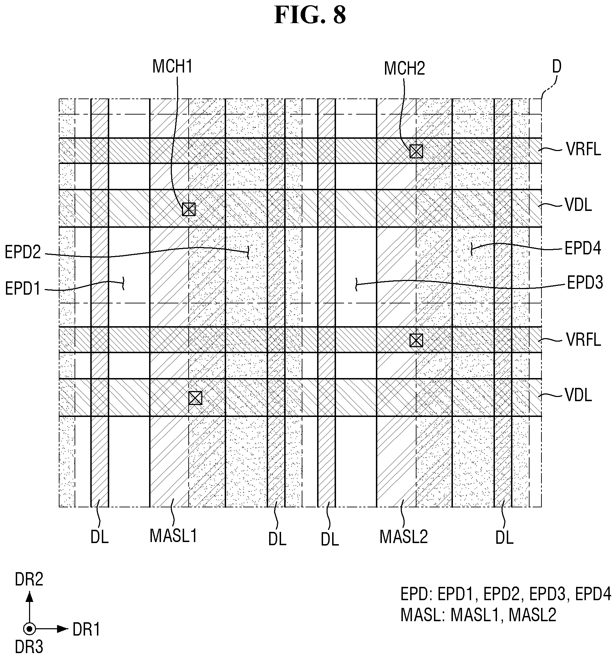

FIG. 7 is a layout view illustrating a portion C of FIG. 6. FIG. 8 is a schematic plan view illustrating a portion D of FIG. 7.

Referring to FIGS. 7 and 8, since the display device 100 is substantially the same as the display device 100 illustrated in FIGS. 1 to 6, except that the light emitting pixel drivers EPD include a first light emitting pixel driver EPD1, a second light emitting pixel driver EPD2, a third light emitting pixel driver EPD3, and a fourth light emitting pixel driver EPD4 adjacent to each other in the first direction DR1, the first mesh auxiliary line MASL1 is disposed adjacent to a boundary between the first light emitting pixel driver EPD1 and the second light emitting pixel driver EPD2, and the second mesh auxiliary line MASL2 is disposed adjacent to a boundary between the third light emitting pixel driver EPD3 and the fourth light emitting pixel driver EPD4, redundant descriptions will be omitted below.

As illustrated in FIGS. 7 and 8, each of the light emitting pixel drivers EPD may overlap at least one of the first power lines VDL and at least one of the second power lines VRFL.

For example, the first light emitting pixel driver EPD1, the second light emitting pixel driver EPD2, the third light emitting pixel driver EPD3, and the fourth light emitting pixel driver EPD4 adjacent to each other in the first direction DR1 may overlap a corresponding first power line VDL and a corresponding second power line VRFL.

As illustrated in FIGS. 7 and 8, the first mesh auxiliary line MASL1 may be connected (e.g., electrically connected) to the first power lines VDL through first mesh connection holes MCH1.

For example, the second mesh auxiliary line MASL2 may be connected (e.g., electrically connected) to the second power lines VRFL through second mesh connection holes MCH2.

The first mesh auxiliary line MASL1 may be adjacent to or may overlap the boundary between the first light emitting pixel driver EPD1 and the second light emitting pixel driver EPD2.

Accordingly, the first mesh connection holes MCH1 for electrical connection between the first mesh auxiliary line MASL1 and the first power lines VDL may be adjacent to or may overlap the boundary between the first light emitting pixel driver EPD1 and the second light emitting pixel driver EPD2. For example, the first mesh connection holes MCH1 may overlap the first light emitting pixel driver EPD1 or the second light emitting pixel driver EPD2.

On a side in the first direction DR1, the first mesh auxiliary line MASL1 may be adjacent to the data line DL connected (e.g., electrically connected) to the first light emitting pixel driver EPD1.

On another side in the first direction DR1, the first mesh auxiliary line MASL1 may be adjacent to the data line DL connected (e.g., electrically connected) to the second light emitting pixel driver EPD2.

On another side in the first direction DR1, the data line DL connected (e.g., electrically connected) to the second light emitting pixel driver EPD2 may face the data line DL connected (e.g., electrically connected) to the third light emitting pixel driver EPD3.

The second mesh auxiliary line MASL2 may be adjacent to or may overlap the boundary between the third light emitting pixel driver EPD3 and the fourth light emitting pixel driver EPD4. For example, the second mesh connection holes MCH2 may overlap the third light emitting pixel driver EPD3 or the fourth light emitting pixel driver EPD4.

Accordingly, the second mesh connection holes MCH2 for electrical connection between the second mesh auxiliary line MASL2 and the second power lines VRFL may be adjacent to or may overlap the boundary between the third light emitting pixel driver EPD3 and the fourth light emitting pixel driver EPD4.

On a side in the first direction DR1, the second mesh auxiliary line MASL2 may be adjacent to the data line DL connected (e.g., electrically connected) to the third light emitting pixel driver EPD3.

On another side in the first direction DR1, the second mesh auxiliary line MASL2 may be adjacent to the data line DL connected (e.g., electrically connected) to the fourth light emitting pixel driver EPD4.

As described above, as illustrated in FIGS. 7 and 8, a corresponding first mesh auxiliary line MASL1 and a corresponding second mesh auxiliary line MASL2 are disposed in each of the four light emitting pixel drivers EPD adjacent to each other in the first direction DR1. Therefore, in the case that the light emitting pixel drivers EPD are arranged in a matrix with N columns (where N is the number of light emitting pixel drivers EPD parallel to each other in the first direction DR1) and M rows (where M is the number of light emitting pixel drivers EPD parallel to each other in the second direction DR2), the number of mesh auxiliary lines MASL may be reduced to N/2 instead of N. As a result, this may be advantageous in increasing a resolution of the display device 100.

As illustrated in FIG. 4, among the light emitting areas EA, the first light emitting areas EA1 and the third light emitting areas EA3 may arranged to alternate with each other in the first direction DR1, and the second light emitting areas EA2 may be arranged to be parallel to each other in the first direction DR1 and may be adjacent to the first light emitting areas EA1 and the third light emitting areas EA3 in a fourth direction DR4 or a fifth direction DR5.

Accordingly, each of the first light emitting pixel driver EPD1 and the third light emitting pixel driver EPD3 may be connected (e.g., electrically connected) to one of the light emitting elements LE of the first light emitting area EA1 and the light emitting element LE of the third light emitting area EA3, and each of the second light emitting pixel driver EPD2 and the fourth light emitting pixel driver EPD4 may be connected (e.g., electrically connected) to the light emitting element LE of the second light emitting area EA2.

As illustrated in FIGS. 7 and 8, as the second mesh auxiliary line MASL2 connected (e.g., electrically connected) to the second power lines VRFL is disposed adjacent to the boundary between the third light emitting pixel driver EPD3 and the fourth light emitting pixel driver EPD4, the first light emitting pixel driver EPD1 and the second light emitting pixel driver EPD2 are relatively far apart from the second mesh auxiliary line MASL2. As a result, a voltage level of the third power (e.g., VREF in FIG. 5) applied to the second light emitting pixel driver EPD2 may be different from a voltage level of the third power (e.g., VREF in FIG. 5) applied to the third light emitting pixel driver EPD3 or the fourth light emitting pixel driver EPD4. As a result, as the luminance of the light emitting element LE of the second light emitting area EA2 connected (e.g., electrically connected) to the second light emitting pixel driver EPD2 decreases, image quality problems such as spots may occur.

Accordingly, a display device 100 is provided in which the second mesh auxiliary lines MASL2 connected (e.g., electrically connected) to the second power lines VRFL may be disposed adjacent to all light emitting pixel drivers EPD.

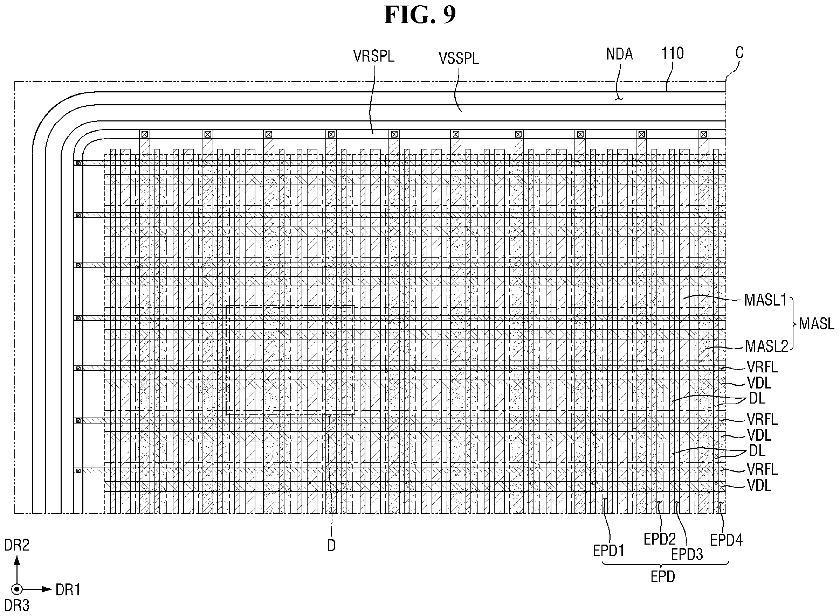

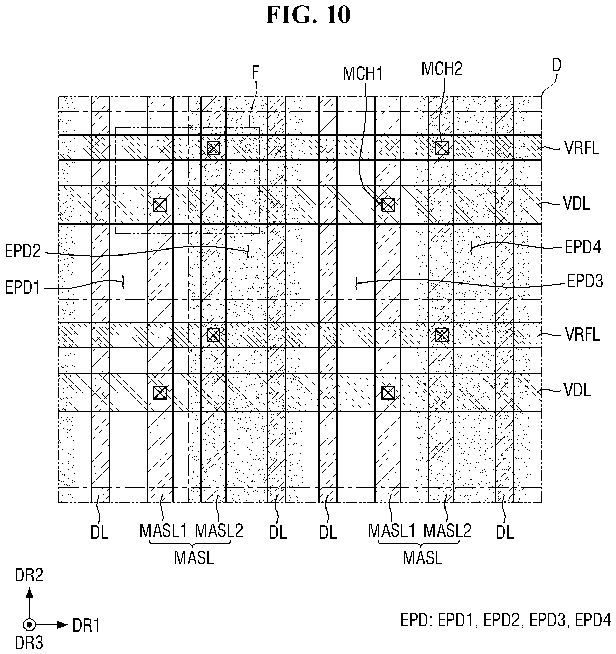

FIG. 9 is a layout view illustrating a portion C of FIG. 6 in another implementation. FIG. 10 is a schematic plan view illustrating a portion D of FIG. 9.

Referring to FIGS. 9 and 10, since the display device 100 is substantially the same as the display device 100 illustrated in FIGS. 1 to 6 and the display device 100 illustrated in FIGS. 7 and 8, except that the light emitting pixel drivers EPD include a first light emitting pixel driver EPD1 and a second light emitting pixel driver EPD2 adjacent to each other in the first direction DR1, the first mesh auxiliary line MASL1 is disposed adjacent to a boundary between the first light emitting pixel driver EPD1 and the second light emitting pixel driver EPD2 and overlaps the first light emitting pixel driver EPD1, and the second mesh auxiliary line MASL2 is disposed adjacent to the boundary between the first light emitting pixel driver EPD1 and the second light emitting pixel driver EPD2 and overlaps the second light emitting pixel drivers EPD2, redundant descriptions will be omitted below.

As illustrated in FIGS. 9 and 10, a corresponding first mesh auxiliary line MASL1 and a corresponding second mesh auxiliary line MASL2 among the mesh auxiliary lines MASL may be disposed adjacent to the boundary between the first light emitting pixel driver EPD1 and the second light emitting pixel driver EPD2.

A corresponding first mesh auxiliary line MASL1 may overlap the first light emitting pixel driver EPD1. Accordingly, the first mesh connection holes MCH1 for electrical connection between the first mesh auxiliary line MASL1 and the first power lines VDL may overlap the first light emitting pixel driver EPD1.

A corresponding second mesh auxiliary line MASL2 may overlap the second light emitting pixel driver EPD2. Accordingly, the second mesh connection holes MCH2 for electrical connection between the second mesh auxiliary line MASL2 and the second power lines VRFL may overlap the second light emitting pixel driver EPD2.

For example, the light emitting pixel drivers EPD may further include a third light emitting pixel driver EPD3 and a fourth light emitting pixel driver EPD4 arranged to be parallel to the first light emitting pixel driver EPD1 and the second light emitting pixel driver EPD2 in the first direction DR1 and adjacent to each other.

Another first mesh auxiliary line MASL1 and another second mesh auxiliary line MASL2 among the mesh auxiliary lines MASL may be disposed adjacent to the boundary between the third light emitting pixel driver EPD3 and the fourth light emitting pixel driver EPD4.

Another first mesh auxiliary line MASL1 may overlap the third light emitting pixel driver EPD3.

Another second mesh auxiliary line MASL2 may overlap the fourth light emitting pixel driver EPD4.

As described above, since all light emitting pixel drivers EPD are disposed adjacent to each of the first mesh auxiliary line MASL1 and the second mesh auxiliary line MASL2, the light emitting pixel drivers EPD may be relatively stably supplied with the first power ELVDD and the third power VREF.

For example, as each of the second light emitting pixel driver EPD2 and the fourth light emitting pixel driver EPD4 connected (e.g., electrically connected) to the light emitting elements LE of the second light emitting areas EA2 overlaps the second mesh auxiliary line MASL2 transmitting the third power VREF, each of the second light emitting pixel driver EPD2 and the fourth light emitting pixel driver EPD4 may be more stably supplied with the third power VREF for compensating for the potential of the gate electrode of the first transistor T1.

Considering that the light emitting elements LE of the second light emitting areas EA2 emit light having a luminance that varies relatively sensitively to the magnitude of the driving current, in the case that the third power VREF with a more stable voltage level is applied to the second light emitting pixel driver EPD2 and the fourth light emitting pixel driver EPD4, improvement in image quality of the display device 100 may be easily expected.

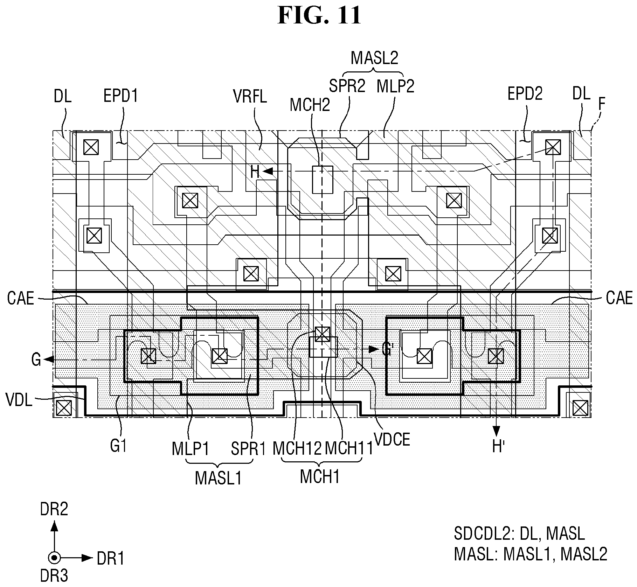

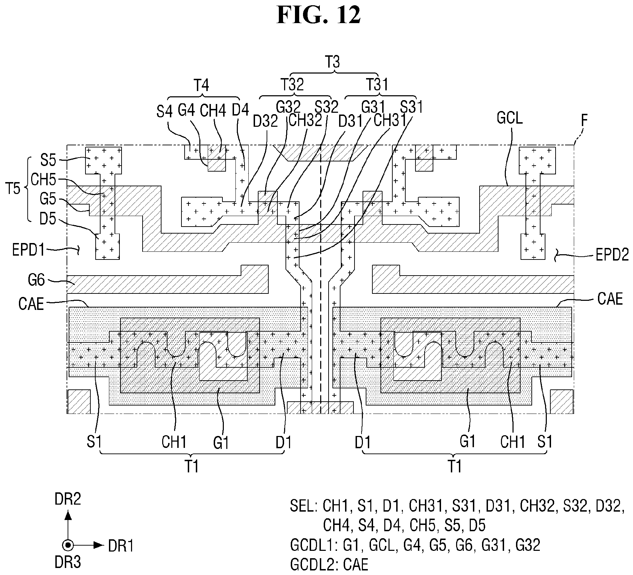

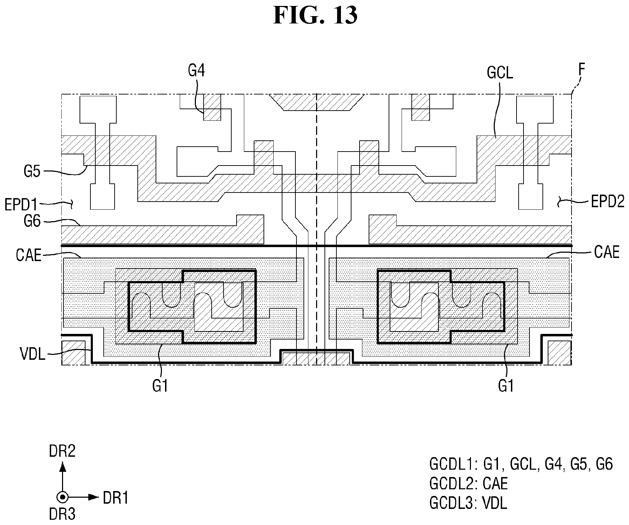

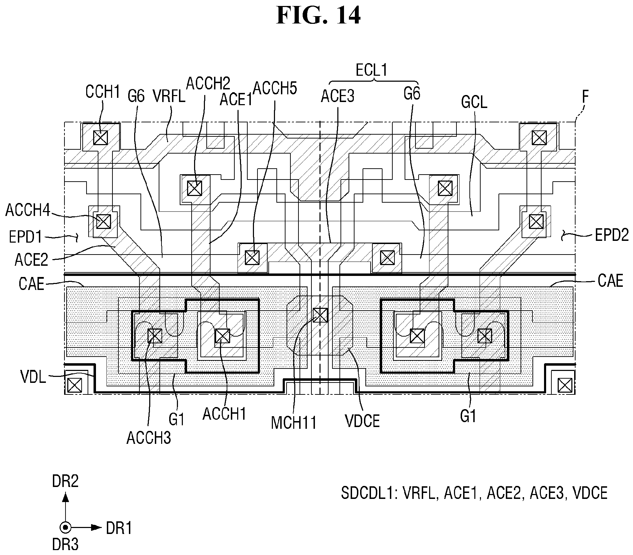

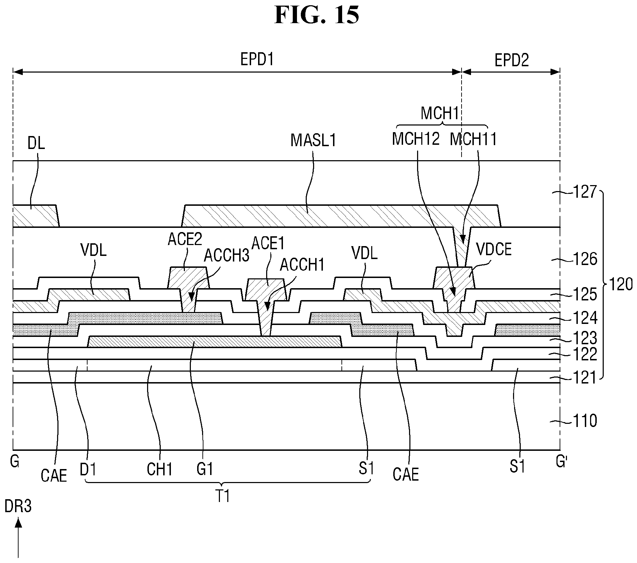

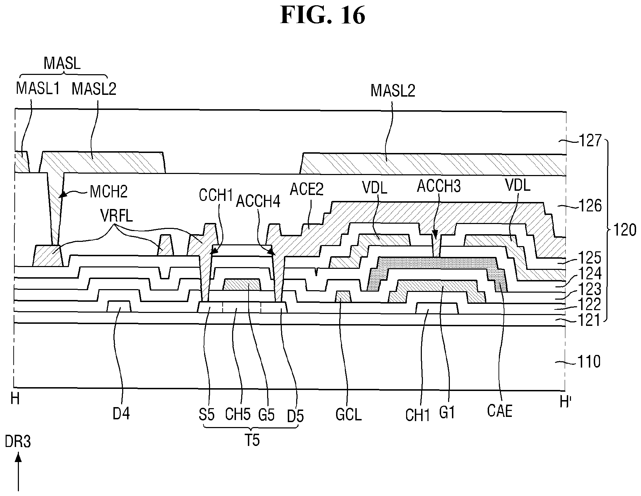

FIG. 11 is a schematic plan view illustrating a portion F of FIG. 10. FIG. 12 is a schematic plan view illustrating a semiconductor layer, a first gate conductive layer, and a second gate conductive layer in the schematic plan view of FIG. 11. FIG. 13 is a schematic plan view illustrating a semiconductor layer, a first gate conductive layer, a second gate conductive layer, and a third gate conductive layer in the schematic plan view of FIG. 11. FIG. 14 is a plan view illustrating a semiconductor layer, a first gate conductive layer, a second gate conductive layer, a third gate conductive layer, and a first source drain conductive layer in the schematic plan view of FIG. 11. FIG. 15 is a schematic cross-sectional view taken along line G-G' of FIG. 11. FIG. 16 is a schematic cross-sectional view taken along line H-H' of FIG. 11.

Referring to FIGS. 15 and 16, the circuit layer 120 of the display device 100 may include a semiconductor layer (e.g., SEL: CH1, S1, D1, CH31, S31, D31, CH32, S32, D32, CH4, S4, and D4 in FIG. 12) disposed on the substrate 110, a first gate insulating layer 122 covering the semiconductor layer, a first gate conductive layer (e.g., GCDL1: G1, GCL, G31, G32, G4, G5, G6 in FIGS. 12 and 13) disposed on the first gate insulating layer 122, a second gate insulating layer 123 covering the first gate conductive layer, a second gate conductive layer (e.g., GCDL2: CAE in FIGS. 12 and 13) disposed on the second gate insulating layer 123, a third gate insulating layer 124 covering the second gate conductive layer, a third gate conductive layer (e.g., VDL in FIG. 13) disposed on the third gate insulating layer 124, an interlayer insulating layer 125 covering the third gate conductive layer, a first source-drain conductive layer (e.g., SDCDL1: VRFL, ACE1, ACE2, ACE3, VDCE in FIG. 14) disposed on the interlayer insulating layer, a first planarization layer 126 covering the first source-drain conductive layer, a second source-drain conductive layer (e.g., SDCDL2: DL, MASL in FIG. 11) disposed on the first planarization layer 126, and a second planarization layer 127 covering the second source-drain conductive layer.

For example, the circuit layer 120 may further include a buffer layer 121 covering the substrate 110. In this case, the semiconductor layer (e.g., SEL: CH1, S1, D1, CH31, S31, D31, CH32, S32, D32, CH4, S4, and D4 in FIG. 12) may be disposed on the buffer layer 121.

As illustrated in FIG. 12, the first transistor T1 may include a channel CH1, a first electrode S1, a second electrode D1, and a gate electrode G1. The channel CH1, the first electrode S1, and the second electrode D1 of the first transistor T1 may be disposed on the semiconductor layer SEL. The first electrode S1 and the second electrode D1 of the first transistor T1 may be connected (e.g., electrically connected) to sides (e.g., opposite sides) of the channel CH1. The gate electrode G1 of the first transistor T1 may be formed as the first gate conductive layer GCDL1 and may overlap the channel CH1 of the first transistor T1.

The third transistor T3 may include a first sub-transistor T31 and a second sub-transistor T32 connected in series.

The first sub-transistor T31 may include a channel CH31, a first electrode S31, a second electrode D31, and a gate electrode G31. The channel CH31, the first electrode S31, and the second electrode D31 of the first sub-transistor T31 may be disposed on the semiconductor layer SEL. The first electrode S31 and the second electrode D31 of the first sub-transistor T31 may be connected (e.g., electrically connected) to sides (e.g., opposite sides) of the channel CH31. The gate electrode G31 of the first sub-transistor T31 may be formed as the first gate conductive layer GCDL1 and may overlap the channel CH31 of the first sub-transistor T31.

The second sub-transistor T32 may include a channel CH32, a first electrode S32, a second electrode D32, and a gate electrode G32. The channel CH32, the first electrode S32, and the second electrode D32 of the second sub-transistor T32 may be disposed on the semiconductor layer SEL. The first electrode S32 and the second electrode D32 of the second sub-transistor T32 may be connected (e.g., electrically connected) to sides (e.g., opposite sides) of the channel CH32. The gate electrode G32 of the second sub-transistor T32 may be formed as the first gate conductive layer GCDL1 and may overlap the channel CH32 of the second sub-transistor T32.

The first electrode S31 of the first sub-transistor T31 may be connected (e.g., electrically connected) to the second electrode D1 of the first transistor T1.

The second electrode D31 of the first sub-transistor T31 may be connected (e.g., electrically connected) to the first electrode S32 of the second sub-transistor T32.

The gate electrode G31 of the first sub-transistor T31 and the gate electrode G32 of the second sub-transistor T32 may be formed as different portions of the gate control line GCL.

The gate control line GCL may be formed as the first gate conductive layer GCDL1.

The fourth transistor T4 may include a channel CH4, a first electrode S4, a second electrode D4, and a gate electrode G4. The channel CH4, the first electrode S4, and the second electrode D4 of the fourth transistor T4 may be disposed on the semiconductor layer SEL. The first electrode S4 and the second electrode D4 of the fourth transistor T4 may be connected (e.g., electrically connected) to sides (e.g., opposite sides) of the channel CH4. The gate electrode G4 of the fourth transistor T4 may be formed as the first gate conductive layer GCDL1 and may overlap the channel CH4 of the fourth transistor T4.

The second electrode D4 of the fourth transistor T4 may be connected (e.g., electrically connected) to the second electrode D32 of the second sub-transistor T32.

The fifth transistor T5 may include a channel CH5, a first electrode S5, a second electrode D5, and a gate electrode G5. The channel CH5, the first electrode S5, and the second electrode D5 of the fifth transistor T5 may be disposed on the semiconductor layer SEL. The first electrode S5 and the second electrode D5 of the fifth transistor T5 may be connected (e.g., electrically connected) to sides (e.g., opposite sides) of the channel CH5. The gate electrode G5 of the fifth transistor T5 may be formed as the first gate conductive layer GCDL1 and may overlap the channel CH5 of the fifth transistor T5.

The gate electrode G5 of the fifth transistor T5 may be provided (or formed) as another portion of the gate control line GCL.

The gate electrode G6 of the sixth transistor (e.g., T6 in FIG. 5) may be formed as the first gate conductive layer GCDL1.

For example, since the second transistor (e.g., T2 in FIG. 5), the sixth transistor T6, the seventh transistor (e.g., T7 in FIG. 5), the eighth transistor (e.g., T8 in FIG. 5), and the ninth transistor (e.g., T9 in FIG. 5) have a similar structure to the first transistor T1, the first sub-transistor T31, the second sub-transistor T32, the fourth transistor T4, and the fifth transistor T5 in the case of being provided (or formed) as the N-type MOSFET like the first transistor T1, the first sub-transistor T31, the second sub-transistor T32, the fourth transistor T4, and the fifth transistor T5, redundant descriptions will be omitted below.

The capacitor electrode CAE may be formed as the second gate conductive layer GCDL2.

The capacitor electrode CAE may overlap the gate electrode G1 of the first transistor T1. As a result, the first pixel capacitor (e.g., PC1 in FIG. 5) may be provided by an overlapping area between the gate electrode G1 of the first transistor T1 and the capacitor electrode CAE.

The semiconductor layer SEL, the first gate conductive layer GCDL1, and the second gate conductive layer GCDL2 of the first light emitting pixel driver EPD1 may be symmetrical to the semiconductor layer SEL, the first gate conductive layer GCDL1, and the second gate conductive layer GCDL2 of the second light emitting pixel driver EPD2 adjacent to the first light emitting pixel driver EPD1 in the first direction DR1.

Referring to FIG. 13, the first power line VDL may be formed as the third gate conductive layer GCDL3.

The first power line VDL may extend in the first direction DR1 and may overlap the capacitor electrode CAE. As a result, the second pixel capacitor (e.g., PC2 in FIG. 5) may be provided by an overlapping area between the capacitor electrode CAE and the first power line VDL.

Referring to FIG. 14, the second power line VRFL, the first auxiliary connection electrode ACE1, the second auxiliary connection electrode ACE2, the third auxiliary connection electrode ACE3, and the power connection electrode VDCE may be disposed on the first source-drain conductive layer SDCDL1.

The second power line VRFL may extend in the first direction DR1.

The second power line VRFL may include a protruding portion that overlaps the boundary between the first light emitting pixel driver EPD1 and the second light emitting pixel driver EPD2.

As illustrated in FIGS. 14 and 16, a portion of the second power line VRFL may overlap the first electrode S5 of the fifth transistor T5 and the first connection hole CCH1. Accordingly, the second power line VRFL may be connected (e.g., electrically connected) to the first electrode S5 of the fifth transistor T5 through the first connection hole CCH1.

As illustrated in FIGS. 12 and 14, an end portion of the first auxiliary connection electrode ACE1 may overlap a portion of the semiconductor layer (e.g., SEL in FIG. 12) connected to the second electrode (e.g., D32 in FIG. 12) of the second sub-transistor (e.g., T32 in FIG. 12) and the second electrode (e.g., D4 in FIG. 12) of the fourth transistor (e.g., T4 in FIG. 12), and another end portion of the first auxiliary connection electrode ACE1 may overlap the gate electrode G1 of the first transistor (e.g., T1 in FIG. 12).

As illustrated in FIG. 15, the first auxiliary connection electrode ACE1 may be connected (e.g., electrically connected) to the gate electrode G1 of the first transistor T1 through a first auxiliary connection hole ACCH1.

For example, the first auxiliary connection electrode ACE1 may be connected (e.g., electrically connected) to the second electrode (e.g., D32 in FIG. 12) of the second sub-transistor (e.g., T32 in FIG. 12) and the second electrode (e.g., D4 in FIG. 12) of the fourth transistor (e.g., T4 in FIG. 12) through a second auxiliary connection hole ACCH2.

Accordingly, as the gate electrode G1 of the first transistor T1 is connected (e.g., electrically connected) to the second electrode (e.g., D32 in FIG. 12) of the second sub-transistor (e.g., T32 in FIG. 12) and the second electrode (e.g., D4 in FIG. 12) of the fourth transistor (e.g., T4 in FIG. 12) through the first auxiliary connection electrode ACE1, the third node (N3 in FIG. 5) may be provided.

As illustrated in FIG. 16, the second auxiliary connection electrode ACE2 may be connected (e.g., electrically connected) to the capacitor electrode CAE through a third auxiliary connection hole ACCH3, and may be connected (e.g., electrically connected) to the second electrode D5 of the fifth transistor T5 through a fourth auxiliary connection hole ACCH4.

For example, an extending portion of the second auxiliary connection electrode ACE2 may be connected (e.g., electrically connected) to the second electrode of the second transistor (e.g., T2 in FIG. 5).

Accordingly, an electrical connection between the first pixel capacitor (e.g., PC1 in FIG. 5), the second pixel capacitor (e.g., PC2 in FIG. 5), the fifth transistor (e.g., T5), and the second transistor (e.g., T2 in FIG. 5), e.g., the fourth node (e.g., N4 in FIG. 5) may be provided by the second auxiliary connection electrode ACE2.

As illustrated in FIG. 14, the third auxiliary connection electrode ACE3 may be connected (e.g., electrically connected) to the gate electrode G6 of the sixth transistor T6 of the first light emitting pixel driver EPD1 and the gate electrode G6 of the sixth transistor T6 of the second light emitting pixel driver EPD2 through fifth auxiliary connection holes ACCH5.

Accordingly, as the gate electrodes G6 of the sixth transistors T6 of the light emitting pixel drivers EPD adjacent in the first direction DR1 are connected (e.g., electrically connected) to each other through the third auxiliary connection electrode ACE3, the first emission control line ECL1 may be provided.

The power connection electrode VDCE may be disposed in an island shape overlapping the boundary between the first light emitting pixel driver EPD1 and the second light emitting pixel driver EPD2.

As illustrated in FIG. 11, the data lines DL and the mesh auxiliary lines MASL may extend in the second direction DR2 and may be disposed on the second source-drain conductive layer SDCDL2.

The mesh auxiliary lines MASL may include a first mesh auxiliary line MASL1 and a second mesh auxiliary line MASL2 disposed adjacent to the boundary between the first light emitting pixel driver EPD1 and the second light emitting pixel driver EPD2 adjacent to each other in the first direction DR1.

The first mesh auxiliary line MASL1 and the second mesh auxiliary line MASL2 may include main line portions MLP1 and MLP2 extending in the second direction DR2, and sub-protruding portions SPR1 and SPR2 protruding from the main line portions MLP1 and MLP2, respectively.

The main line portion MLP1 of the first mesh auxiliary line MASL1 and the main line portion MLP2 of the second mesh auxiliary line MASL2 may be symmetrical to each other based on the boundary between the first light emitting pixel driver EPD1 and the second light emitting pixel driver EPD2.

As illustrated in FIG. 11, the power connection electrode VDCE may overlap the first mesh connection hole MCH1 and the sub-protruding portion SPR1 of the first mesh auxiliary line MASL1.

The first mesh auxiliary line MASL1 may be connected (e.g., electrically connected) to the first power line VDL through the first mesh connection hole MCH1 and the power connection electrode VDCE.

For example, as illustrated in FIG. 15, the power connection electrode VDCE may be connected (e.g., electrically connected) to the first mesh auxiliary line MASL1 through a first mesh auxiliary connection hole MCH11, and may be connected (e.g., electrically connected) to the first power line VDL through a second mesh auxiliary connection hole MCH12.

For example, the first mesh connection hole MCH1 for electrical connection between the first mesh auxiliary line MASL1 and the first power line VDL may include a first mesh auxiliary connection hole MCH11 and a second mesh auxiliary connection hole MCH12.

The sub-protruding portion SPR2 of the second mesh auxiliary line MASL2 may overlap the protruding portion of the second power line VRFL and the second mesh connection hole MCH2.

Accordingly, as illustrated in FIG. 16, the second mesh auxiliary line MASL2 may be connected (e.g., electrically connected) to the second power lines VRFL through second mesh connection hole MCH2.

However, the effects of the disclosure are not restricted to the one set forth herein. The above and other effects of the disclosure will become more apparent to one of skill in the art to which the disclosure pertains by referencing the claims.

## Claims

1. A display device comprising:
a substrate (110);
a circuit layer (120) disposed on the substrate; and
an element layer (130) disposed on the circuit layer, wherein
the substrate (110) includes a display area (DA) in which light emitting areas are arranged, and a non-display area (NDA) disposed around the display area,
the element layer (130) includes light emitting elements (LE) disposed in the light emitting areas,
the circuit layer (120) includes:
a first power supply line (VDSPL) and a second power supply line (VSSPL) disposed in the non-display area and transmitting first power (ELVDD) and second power (ELVSS) for driving the light emitting elements, respectively;
light emitting pixel drivers (EPD) electrically connected to the light emitting elements and arranged to be parallel to each other in a first direction and a second direction;
first power lines (VDL) extending in the first direction and electrically connected between the first power supply line (VDSPL) and the light emitting pixel drivers (EPD);
second power lines (VRFL) extending in the first direction and transmitting a third power (VREF) different from the first power (ELVDD) and the second power (ELVSS) to the light emitting pixel drivers (EPD); and
mesh auxiliary lines (MASL) extending in the second direction,
the mesh auxiliary lines including:
a first mesh auxiliary line (MASL1) electrically connected to the first power lines (VDL); and
a second mesh auxiliary line (MASL2) electrically connected to the second power lines (VRFL).

2. The display device of claim 1, wherein
the circuit layer further includes data lines extending in the second direction and transmitting data signals to the light emitting pixel drivers,
the data lines are adjacent to the mesh auxiliary lines,
each of the light emitting elements is electrically connected between each of the light emitting pixel drivers and the second power,
each of the light emitting pixel drivers includes:
a first transistor electrically connected between a first node and a second node;
a first pixel capacitor electrically connected between a third node and a fourth node;
a second transistor electrically connected between a corresponding data line of the data lines and the fourth node;
a third transistor electrically connected between the second node and the third node;
a fourth transistor electrically connected between a first initialization voltage line transmitting a first initialization voltage and the third node;
a fifth transistor electrically connected between a corresponding second power line of the second power lines and the fourth node; and
a second pixel capacitor electrically connected between a corresponding first power line of the first power lines and the fourth node,
the first node is electrically connected to a first electrode of the first transistor,
the second node is electrically connected to a second electrode of the first transistor, and
the third node is electrically connected to a gate electrode of the first transistor.

3. The display device of claim 2, wherein
each of the light emitting pixel drivers further includes:
a sixth transistor electrically connected between the corresponding first power line and the first node;
a seventh transistor electrically connected between the second node and a fifth node;
an eighth transistor electrically connected between a bias voltage line transmitting a bias voltage and the first node; and
a ninth transistor electrically connected between a second initialization voltage line transmitting a second initialization voltage and the fifth node, and
the fifth node is electrically connected to each of the light emitting elements.

4. The display device of claim 3, wherein
the second transistor is turned on by a scan write signal of a scan write line,
the third transistor and the fifth transistor are turned on by a gate control signal of a gate control line,
the fourth transistor is turned on by a scan initialization signal of a scan initialization line,
the sixth transistor is turned on by a first emission control signal of a first emission control line,
the seventh transistor is turned on by a second emission control signal of a second emission control line, and
the eighth transistor and the ninth transistor are turned on by a bias control signal of a bias control line.

5. The display device of claim 2, 3 or 4, wherein
the first power lines and the second power lines are arranged to alternate with each other in the second direction, and
each of the light emitting pixel drivers overlaps the corresponding first power line and the corresponding second power line.

6. The display device of claim 5, wherein the mesh auxiliary lines are disposed on one or more insulating layers covering the first power lines and one or more insulating layers covering the second power lines.

7. The display device of claim 5 or 6, wherein
the circuit layer further includes a third power supply line disposed in the non-display area and transmitting the third power, and
each of the second power lines and the second mesh auxiliary line extends into the non-display area and is electrically connected to the third power supply line.

8. The display device of claim 7, wherein
the light emitting pixel drivers include a first light emitting pixel driver, a second light emitting pixel driver, a third light emitting pixel driver, and a fourth light emitting pixel driver that are adjacent to each other in the first direction,
the first mesh auxiliary line is disposed adjacent to a boundary between the first light emitting pixel driver and the second light emitting pixel driver,
the second mesh auxiliary line is disposed adjacent to a boundary between the third light emitting pixel driver and the fourth light emitting pixel driver,
the corresponding first power line and the corresponding second power line overlap the first light emitting pixel driver, the second light emitting pixel driver, the third light emitting pixel driver, and the fourth light emitting pixel driver,
the corresponding first power line is electrically connected to the first mesh auxiliary line through a first mesh connection hole,
the corresponding second power line is electrically connected to the second mesh auxiliary line through a second mesh connection hole,
the first mesh connection hole overlaps the first light emitting pixel driver or the second light emitting pixel driver, and
the second mesh connection hole overlaps the third light emitting pixel driver or the fourth light emitting pixel driver.

9. The display device of claim 7, wherein
the light emitting pixel drivers include a first light emitting pixel driver and a second light emitting pixel driver that are adjacent to each other in the first direction,
the first mesh auxiliary line is adjacent to a boundary between the first light emitting pixel driver and the second light emitting pixel driver, and overlaps the first light emitting pixel driver,
the second mesh auxiliary line is adjacent to the boundary between the first light emitting pixel driver and the second light emitting pixel driver, and overlaps the second light emitting pixel driver,
the corresponding first power line and the corresponding second power line overlap the first light emitting pixel driver and the second light emitting pixel driver,
the corresponding first power line is electrically connected to the first mesh auxiliary line through a first mesh connection hole,
the corresponding second power line is electrically connected to the second mesh auxiliary line through a second mesh connection hole,
the first mesh connection hole overlaps the first light emitting pixel driver, and the second mesh connection hole overlaps the second light emitting pixel driver.

10. The display device of claim 9, wherein
the light emitting areas include:
first light emitting areas emitting light of a first color;
second light emitting areas emitting light of a second color in a lower wavelength band than the first color; and
third light emitting areas emitting light of a third color in a lower wavelength band than the second color,
the first light emitting areas and the third light emitting areas are arranged to alternate with each other in the second direction,
the second light emitting areas are arranged to be parallel to each other in the second direction,
the first light emitting pixel driver is electrically connected to a light emitting element of one of the first light emitting areas and the third light emitting areas, and
the second light emitting pixel driver is electrically connected to a light emitting element of the second light emitting areas.

11. The display device of claim 9, wherein
the circuit layer includes:
a semiconductor layer disposed on the substrate;
a first gate insulating layer covering the semiconductor layer;
a first gate conductive layer disposed on the first gate insulating layer;
a second gate insulating layer covering the first gate conductive layer;
a second gate conductive layer disposed on the second gate insulating layer;
a third gate insulating layer covering the second gate conductive layer;
a third gate conductive layer disposed on the third gate insulating layer;
an interlayer insulating layer covering the third gate conductive layer;
a first source-drain conductive layer disposed on the interlayer insulating layer;
a first planarization layer covering the first source-drain conductive layer;
a second source-drain conductive layer disposed on the first planarization layer; and
a second planarization layer covering the second source-drain conductive layer,
the first power lines are formed as the third gate conductive layer,
the second power lines are formed as the first source-drain conductive layer, and
the mesh auxiliary lines are formed as the second source-drain conductive layer.

12. The display device of claim 11, wherein
the circuit layer further includes a capacitor electrode formed as the second gate conductive layer and electrically connected to the fourth node,
the gate electrode of the first transistor is formed as the first gate conductive layer,
the first pixel capacitor is formed between the capacitor electrode and the gate electrode of the first transistor, and
the second pixel capacitor is formed between the capacitor electrode and the first power line.

13. The display device of claim 9, wherein
each of the first mesh auxiliary line and the second mesh auxiliary line includes a main line portion extending in the second direction and a sub-protruding portion protruding from the main line portion,
the circuit layer further includes a power connection electrode overlapping the sub-protruding portion of the first mesh auxiliary line and the first mesh connection hole,
the power connection electrode is electrically connected to the first mesh auxiliary line through a first mesh auxiliary connection hole, and is electrically connected to the corresponding first power line through a second mesh auxiliary connection hole,
the first mesh connection hole includes the first mesh auxiliary connection hole and the second mesh auxiliary connection hole, and
the sub-protruding portion of the second mesh auxiliary line overlaps a portion of the corresponding second power line and the second mesh connection hole.

14. The display device of claim 13, wherein the main line portion of the first mesh auxiliary line and the main line portion of the second mesh auxiliary line are symmetrical to each other based on the boundary between the first light emitting pixel driver and the second light emitting pixel driver.

15. The display device according to any one of the preceding claims, wherein the first mesh auxiliary lines and the second mesh auxiliary lines are arranged to alternate with each other in the first direction.
